# EUROPEAN PATENT SPECIFICATION

(11) **EP 4 636 418 B1**
(45) Date of publication and mention of the grant of the patent: **09.12.2026**
(21) Application number: 25159996.5
(22) Date of filing: 25.02.2025
(51) Int. Cl.: G01R 31/367, G01R 31/3835, G01R 31/3842, G01R 31/396

(54) **METHOD AND SYSTEM FOR ESTIMATING BATTERY STATE BASED ON COMPOSITE PROBABILITY VARIABLE**
VERFAHREN UND SYSTEM ZUR SCHÄTZUNG DES BATTERIEZUSTANDS AUF DER BASIS EINER ZUSAMMENGESETZTEN WAHRSCHEINLICHKEITSVARIABLEN
PROCÉDÉ ET SYSTÈME D'ESTIMATION D'ÉTAT DE BATTERIE SUR LA BASE D'UNE VARIABLE DE PROBABILITÉ COMPOSITE

(30) Priority: 15.04.2024 KR 20240050297
(43) Date of publication of application: 22.10.2025
(73) Proprietor: SAMSUNG SDI CO., LTD., Yongin-si, Gyeonggi-do 17084 (KR)
(72) Inventor: Yu, Jae-Seung, 17084 Yongin-Si, Gyeonggi-do (KR); Kim, Minsu, 17084 Yongin-Si, Gyeonggi-do (KR)
(74) Representative: Gulde & Partner

(56) References cited:
- EP-B1- 3 437 152
- WO-A1-2022/101769
- WO-A1-2023/136455
- US-A1- 2017 045 587
- US-A1- 2021 155 117
- US-A1- 2022 176 845
- US-A1- 2022 221 516
- US-A1- 20230 375 626
- LIN YU-HSIU ET AL: "Novel cell screening and prognosing based on neurocomputing-based multiday-ahead time-series forecasting for predictive maintenance of battery modules in frequency regulation-energy storage systems", APPLIED ENERGY, ELSEVIER SCIENCE PUBLISHERS, GB, vol. 351, 12 September 2023 (2023-09-12), XP087418081, ISSN: 0306-2619, [retrieved on 20230912], DOI: 10.1016/J.APENERGY.2023.121867
- WANG YONGCHAO ET AL: "Multi-Fault Diagnosis of Interacting Multiple Model Batteries Based on Low Inertia Noise Reduction", IEEE ACCESS, IEEE, USA, vol. 9, 18 January 2021 (2021-01-18), pages 18465 - 18480, XP011834600, DOI: 10.1109/ACCESS.2021.3051986
- LIN CHENG ET AL: "A novel multi-model probability battery state of charge estimation approach for electric vehicles using H-infinity algorithm", APPLIED ENERGY, ELSEVIER SCIENCE PUBLISHERS, GB, vol. 166, 22 January 2016 (2016-01-22), pages 76 - 83, XP029471188, ISSN: 0306-2619, DOI: 10.1016/J.APENERGY.2016.01.010
- LI YANWEN ET AL: "A multi-model probability SOC fusion estimation approach using an improved adaptive unscented Kalman filter technique", ENERGY, ELSEVIER, AMSTERDAM, NL, vol. 141, 14 November 2017 (2017-11-14), pages 1402 - 1415, XP085312126, ISSN: 0360-5442, DOI: 10.1016/J.ENERGY.2017.11.079
- LEI CHEN ET AL: "A novel combined estimation method of online full-parameter identification and adaptive unscented particle filter for Li-ion batteries SOC based on fractional-order modeling", INTERNATIONAL JOURNAL OF ENERGY RESEARCH, WILEY, CHICHESTER, GB, vol. 45, no. 10, 5 May 2021 (2021-05-05), pages 15481 - 15494, XP071646863, ISSN: 0363-907X, DOI: 10.1002/ER.6817
- AIHUA TANG ET AL: "A multi-model real covariance-based battery state-of-charge fusion estimation method for electric vehicles using ordered weighted averaging operator", INTERNATIONAL JOURNAL OF ENERGY RESEARCH, WILEY, CHICHESTER, GB, vol. 46, no. 12, 13 July 2022 (2022-07-13), pages 17273 - 17284, XP072877505, ISSN: 0363-907X, DOI: 10.1002/ER.8392

## Description

### BACKGROUND

### 1. FIELD

The present invention relates to a method and system for estimating a battery state based on composite probability variables.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

The above information disclosed in this Background section is for enhancement of understanding of the background of the present disclosure, and therefore, it may contain information that does not constitute related (or prior) art.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

The document US2017/045587A1 discloses a method of estimating the SOC of a battery. |

### SUMMARY

Embodiments of the present disclosure provide a method and system for estimating a battery state based on composite probability variables.

These and other aspects and features of the present disclosure will be described in or will be apparent from the following description of embodiments of the present disclosure.

In order to solve the technical problems above, a method of estimating a state of charge of a battery module in accordance with the invention includes obtaining, by a microcontroller unit, a composite probability variable model associated with a plurality of battery cells included in a particular battery module, receiving, by the microcontroller unit, voltage measurement data of a first battery cell of the plurality of battery cells included in the particular battery module, receiving, by the microcontroller unit, voltage measurement data of a second battery cell of the plurality of battery cells included in the particular battery module, estimating, by the microcontroller unit and/or a neural processing unit, an SOC of the particular battery module via a Kalman filter operation based on the composite probability variable model, the voltage measurement data of the first battery cell, and the voltage measurement data of the second battery cell, and outputting the estimated SOC of the particular battery module.

According to some embodiments, the first battery cell may be a battery cell positioned first among the plurality of battery cells connected in series, and the second battery cell may be a battery cell positioned last among the plurality of battery cells connected in series.

According to some embodiments, the microcontroller unit may not receive voltage measurement data associated with some of remaining battery cells other than the first battery cell and the second battery cell out of the plurality of battery cells.

According to some embodiments, the first battery cell may be connected to a first voltage measurement sensor, the second battery cell may be connected to a second voltage measurement sensor, and remaining battery cells other than the first battery cell and the second battery cell out of the plurality of battery cells may not be connected to a voltage measurement sensor.

According to some embodiments, the composite probability variable model may be generated based on a cell voltage deviation model associated with the plurality of battery cells and a sensor error model associated with voltage measurement sensors connected to some of the plurality of battery cells.

According to some embodiments, the composite probability variable model may be generated by assuming that the cell voltage deviation model and the sensor error model are probabilistically independent of each other.

According to some embodiments, the composite probability variable model, the cell voltage deviation model, and the sensor error model may be probability density functions that follow a Gaussian distribution.

According to some embodiments, the receiving the voltage measurement data of the first battery cell may include receiving, by the microcontroller unit, a first voltage measurement of the first battery cell measured at a first time, and receiving, by the microcontroller unit, a second voltage measurement of the first battery cell measured at a second time.

According to some embodiments, the estimating the SOC may include generating, by the microcontroller unit, parameters associated with a Kalman filter, generating, by the neural processing unit, an a posteriori voltage estimate of the first battery cell via a Kalman filter operation based on the generated parameters and the voltage measurement data of the first battery cell, and generating, by the neural processing unit, an a posteriori voltage estimate of the second battery cell via a Kalman filter operation based on the generated parameters and the voltage measurement data of the second battery cell.

According to some embodiments, the generating the parameters may include setting a mean value of the composite probability variable model as an initial state estimate of the Kalman filter, or generating an initial state estimate of the Kalman filter based on at least some of the voltage measurement data of the first battery cell or the voltage measurement data of the second battery cell.

According to some embodiments, the generating the parameters may include generating a measurement noise covariance of the Kalman filter based on a standard deviation value of the composite probability variable model.

According to some embodiments, the estimating the SOC may further include estimating the SOC of the particular battery module via the Kalman filter operation based on the a posteriori voltage estimate of the first battery cell, the a posteriori voltage estimate of the second battery cell, the composite probability variable model, and the generated parameters.

According to some embodiments, the estimating the SOC may further include generating an a posteriori voltage estimate of each of remaining battery cells other than the first battery cell and the second battery cell out of the plurality of battery cells via the Kalman filter operation based on the a posteriori voltage estimate of the first battery cell, the a posteriori voltage estimate of the second battery cell, the composite probability variable model, and the generated parameters, and estimating the SOC of the particular battery module based on the a posteriori voltage estimate of each of the plurality of battery cells.

According to some embodiments, the estimating the SOC may further include estimating the SOC of the particular battery module based on a mean value of the a posteriori voltage estimate of the first battery cell and the a posteriori voltage estimate of the second battery cell.

According to some embodiments, the microcontroller unit may perform cell balancing on the particular battery module based on the estimated SOC.

A computer program stored on a computer-readable recording medium is provided for executing the methods in accordance with some embodiments of the present disclosure on a computer.

A battery system in accordance with the present invention includes a particular battery module including a plurality of battery cells and a battery management master module including a microcontroller unit and a neural processing unit. The battery system is configured such that the microcontroller unit obtains a composite probability variable model associated with the plurality of battery cells included in the particular battery module, the microcontroller unit receives voltage measurement data of a first battery cell of the plurality of battery cells included in the particular battery module from the particular battery module, the microcontroller unit receives voltage measurement data of a second battery cell of the plurality of battery cells included in the particular battery module from the particular battery module, the microcontroller unit and/or the neural processing unit estimates an SOC of the particular battery module via a Kalman filter operation based on the composite probability variable model, the voltage measurement data of the first battery cell, and the voltage measurement data of the second battery cell, and the microcontroller unit outputs the estimated SOC of the particular battery module.

According to some embodiments, the first battery cell may be a battery cell positioned first among the plurality of battery cells connected in series, and the second battery cell may be a battery cell positioned last among the plurality of battery cells connected in series.

According to some embodiments, the microcontroller unit may not receive voltage measurement data associated with some of remaining battery cells other than the first battery cell and the second battery cell out of the plurality of battery cells.

According to some embodiments, the first battery cell may be connected to a first voltage measurement sensor, the second battery cell may be connected to a second voltage measurement sensor, and remaining battery cells other than the first battery cell and the second battery cell out of the plurality of battery cells may not be connected to a voltage measurement sensor.

According to various embodiments of the present disclosure, the battery management master module can estimate the SOC of each battery module quickly and with high accuracy without measuring and monitoring all the state information of all battery cells included in each battery module.

According to various embodiments of the present disclosure, through MCU-NPU co-processing in which the NPU processes matrix operation tasks required in the SOC estimation process of the battery modules and the MCU and the NPU feed back to each other, the battery management master module can quickly, accurately, and resource-efficiently handle the process of estimating the SOC of each battery module based on the voltage measurement data of some battery cells.

According to various embodiments of the present disclosure, the voltage of each battery cell can be estimated more accurately by taking into account not only the voltage characteristics of the particular type of battery cell itself but also the characteristics of the sensor that measures the corresponding battery cell when estimating the SOC of the battery module. Accordingly, battery state information, such as the SOC and state of health (SOH) of the battery module, can be estimated more precisely.

According to various embodiments of the present disclosure, the MCU can perform main operation tasks such as the pre-processing process of the Kalman filter operation of the NPU, and can optimize the Kalman filter operation via co-processing with the NPU.

According to various embodiments of the present disclosure, the SOC of the battery module can be estimated accurately and quickly without measuring the voltages of all of a plurality of battery cells included in the particular battery module or performing a Kalman filter operation on all of the battery cells. For example, if the battery module has a plurality of battery cells connected in series, the SOC of the battery module can be estimated more accurately using only the voltage measurement data of two battery cells, i.e., the first and last battery cells. Accordingly, the processing time can be shortened when estimating the battery module SOC and the power consumption can be reduced, which in turn can improve the overall performance, service life, durability, etc., of devices equipped with the battery system (e.g., electric vehicles, etc.).

According to various embodiments of the present disclosure, the battery management master module can generate the SOC estimate of the battery module more quickly and accurately by utilizing the information processing system connected to the vehicle with a network beyond the limits of the internal module performance of the vehicle. Further, because the information processing system is present outside the vehicle, the information processing system can compare and analyze information on the vehicle and information on other vehicles in real time. Accordingly, the information processing system can integrate and manage battery state information of a plurality of vehicles.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a configuration diagram of a battery system in accordance with some embodiments of the present disclosure;
FIG. 2 is a block diagram of a battery system in accordance with some embodiments of the present disclosure;
FIG. 3 is a block diagram of a battery system for estimating an SOC of each battery module in accordance with some embodiments of the present disclosure;
FIG. 4 is a diagram showing a composite probability variable-based model used to estimate a battery module SOC according to some embodiments of the present disclosure;
FIG. 5 is a diagram showing an example of estimating an SOC of a battery module according to some embodiments of the present disclosure;
FIG. 6 is a diagram showing an example of a method for estimating an SOC of a battery module based on voltage estimates of some battery cells according to some embodiments of the present disclosure;
FIG. 7 is a flowchart showing a method of estimating a state of charge of a battery module in accordance with some embodiments of the present disclosure;
FIG. 8 is a diagram showing an example in which an NPU is included in a vehicle in accordance with some embodiments of the present disclosure;
FIG. 9 is a diagram showing an example in which a vehicle and an information processing system communicate with each other in accordance with some embodiments of the present disclosure;
FIG. 10 illustrates a battery pack in accordance with some embodiments of the present disclosure;
FIG. 11 illustrates a battery pack in accordance with some embodiments of the present disclosure;
FIG. 12 illustrates a vehicle body and vehicle body parts having a battery pack in accordance with some embodiments of the present disclosure; and
FIG. 13 illustrates a vehicle body and vehicle body parts having a battery pack in accordance with some embodiments of the present disclosure.

### DETAILED DESCRIPTION

Hereinafter, embodiments of the present disclosure will be described, in detail, with reference to the accompanying drawings.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

A battery system includes multiple battery cells, and it is relatively important to accurately identify and manage the state of each cell. For example, electric vehicles use battery packs containing hundreds of cells, so it is advantageous to accurately estimate the state of each cell. A large number of sensors and computational resources are typically required to monitor all of the multiple battery cells, but the use of such resources affects the cost and performance of the product, so improvements related to hardware and the use computational resources are desirable.

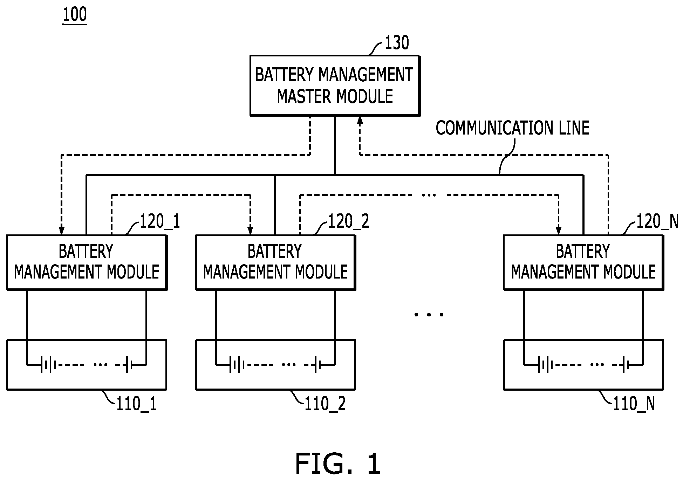

FIG. 1 is a configuration diagram of a battery system 100 in accordance with some embodiments of the present disclosure. The battery system 100 may be configured to monitor the voltages of battery cells to estimate a state of charge (SOC) of a battery module, estimate the SOC of the battery module, and manage the charging and discharging of a battery.

Referring to FIG. 1, the battery system 100 may include one or more battery management modules 120_1, 120_2, ..., 120_N and a battery management master module 130. In some embodiments, each of the one or more battery management modules 120_1, 120_2, ..., 120_N may be connected to a battery module 110_1, 110_2, ..., 110_N comprising a plurality of battery cells, and may be configured to monitor the state of charge of the battery cells in the corresponding battery module. The plurality of battery cells in the battery modules 110_1, 110_2, ..., 110_N may be the same type of battery cells. Further, the battery management master module 130 may be configured to receive state information of the battery cells associated with the corresponding battery management module from the one or more battery management modules 120_1, 120_2, ..., 120_N.

According to some embodiments, the battery system 100 may be configured such that the battery management master module 130 receives information associated with the states of the battery cells from the one or more battery management modules 120_1, 120_2, ..., 120_N in a daisy chain manner. In some embodiments, the battery management module may accumulate state information of the previous battery management modules and transmit it to the next battery management module. For example, a first battery management module 120_1 may receive state information of a first battery module 110_1 and transmit it to a second battery management module 120_2. The second battery management module 120_2 may receive state information of the first battery module 110_1 and a second battery module 110_2 and transmit it to the next battery management module. An N-th battery management module 120_N may transmit state information of the first battery module 110_1 to an N-th battery module 110_N to the battery management master module 130. The specific method of transmitting the state information of the battery cells using the daisy chain method is not limited to the examples described above and can be accomplished in various ways.

According to some embodiments, the battery system 100 may be configured such that the battery management master module 130 receives the state information of the battery cells directly from each battery management module 120_1, 120_2, ..., 120_N. For example, each battery management module 120_1, 120_2, ..., 120_N may be configured to enable direct communicative connection with the battery management master module 130, and each battery management module 120_1, 120_2, ..., 120_N may transmit state information of the corresponding battery cells and/or information associated with defects of the corresponding battery management module to the battery management master module 130. In some embodiments, each battery management module 120_1, 120_2, ..., 120_N may be communicatively connected to the battery management master module 130 via a communication line (e.g., CAN communication).

In some embodiments, the battery management master module 130 may receive voltage measurement data of some battery cells from each battery management module 120_1, 120_2, ..., 120_N, and estimate the SOC of each battery management module 120_1, 120_2, ..., 120_N by using the voltage measurement data of some battery cells received, a composite probability variable model associated with the battery cells, and a Kalman filter operation. The battery management master module 130 may output the estimated SOC value of each battery management module 120_1, 120_2, ..., 120_N, or perform cell balancing based on the estimated SOC value.

According to some embodiments, each battery management module 120_1, 120_2, ..., 120_N may measure a real-time state of each battery module 110_1, 110_2, ..., 110_N connected therewith. Here, the real-time state of each battery module 110_1, 110_2, ..., 110_N may include voltage information of at least some of the plurality of battery cells included in each module. Further, if necessary for estimating the SOC of each battery module, the real-time state of each battery module 110_1, 110_2, ..., 110_N may include, not only voltage, but also current information, temperature information, etc., of at least some of the plurality of battery cells.

According to some embodiments, a first battery management master module 130 may receive state information of at least some of the plurality of battery cells included in the first battery module 110_1 from the battery management module 120_1, and estimate the SOC of the first battery module 110_1 based thereon. Further, the battery management master module 130 may estimate the SOC of the remaining battery management modules 120_2, ..., 120_N in the same manner as above. Thereafter, the battery management master module 130 may perform cell balancing of the battery modules 120_1, 120_2, ..., 120_N based on the respective SOC values of the plurality of battery management modules. Moreover, the battery management master module 130 may output the estimated SOC value.

With such a configuration, the battery management master module 130 can estimate the SOC of each battery module quickly and with high accuracy without measuring and monitoring all the state information of all battery cells included in each battery module.

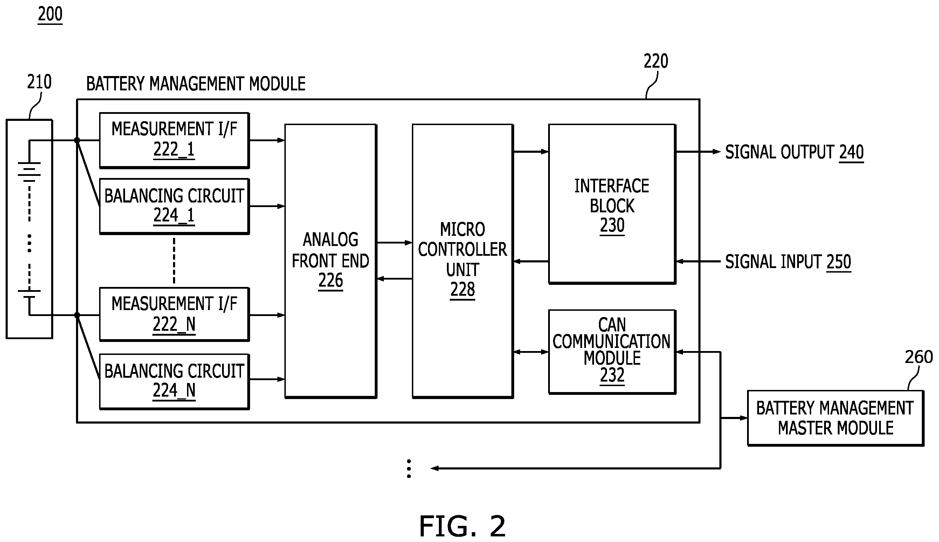

FIG. 2 is a block diagram of a battery system 200 in accordance with some embodiments of the present disclosure. Referring to FIG. 2, a battery management module 220 may be configured to measure the states of battery cells in a battery module 210 and transmit it to a battery management master module 260 and/or a subsequent battery management module. For example, the battery management module 220 may receive state information of the battery cells from the battery module 210 and transmit it to the battery management master module 260 and/or a subsequent battery management module. To this end, the battery management module 220 may include measurement interfaces 222_1, ..., 222_N, balancing circuits 224_1, ..., 224_N, an analog front end 226, a microcontroller unit 228, an interface block 230, and a CAN communication module 232.

The battery management module 220 may be connected to the battery module 210 comprising a plurality of battery cells and may be configured to monitor the states of the battery cells. For example, each measurement interface 222_1, ..., 222_N and each balancing circuit 224_1, ..., 224_N may measure the states of the battery cells, such as voltage, current, and temperature, from each of the battery cells of the battery module 210.

The analog front end 226 may measure the states of the battery cells, such as voltage, current, and temperature, which are analog signals, via each measurement interface 222_1, ..., 222_N and convert them into digital signals. The analog front end 226 may be an integrated circuit. For example, the analog front end 226 may receive state information such as the voltage, current, and temperature of the battery cells, which are analog signals, from each measurement interface 222_1, ..., 222_N and convert them into digital signals. The analog front end 226 may transmit the converted digital signals to the microcontroller unit 228. The analog front end 226 is shown as one in FIG. 2 but is not limited thereto, and the battery management module 220 may include a plurality of analog front ends. For example, the battery management module 220 may include the same number of analog front ends as the number of battery cells.

The microcontroller unit 228 may monitor the states of the battery cells based on the state information such as the voltage, current, and temperature of each battery cell received from the analog front end 226. For example, the microcontroller unit 228 may determine whether a battery cell is in an overvoltage or undervoltage state based on at least one of the pieces of state information such as the voltage, current, and temperature of each battery cell. In another example, the microcontroller unit 228 may sense a voltage difference between battery cells based on at least one of the pieces of state information such as the voltage, current, and temperature of each battery cell. Further, when the microcontroller unit 228 senses a voltage difference between the battery cells, the microcontroller unit 228 may adjust the voltage difference between the battery cells using the balancing circuits 224_1, ..., 224_N to balance the voltage between the battery cells.

According to some embodiments, the battery management module 220 may be configured to transmit information associated with the states of the battery cells to the battery management master module 260 in a daisy chain manner. For example, the microcontroller unit 228 may receive a signal outputted from a previous battery management module (not shown) as an input 250 via the interface block 230. Further, the microcontroller unit 228 may transmit the state information of the battery cells as a signal output 240 to a subsequent battery management module (not shown) via the interface block 230. Here, the state information of the battery cells associated with the previous battery management module may include accumulated state information of the battery cells for the previous battery management modules connected in a daisy chain manner, but is not limited thereto. In this case, each of the first battery management module and the last battery management module may be connected to the battery management master module 260.

According to some embodiments, the battery management module 220 may directly transmit the state information of the battery module 210 (e.g., the state information of the battery cells, etc.) and the state information of the battery management module 220 (e.g. the fault information of the battery management module, etc.) to the battery management master module 260. For example, the microcontroller unit 228 may transmit the state information of the battery module 210 and the state information of the battery management module 220 to the battery management master module 260 via the CAN communication module 232. In this case, all the battery management modules may communicate directly with the battery management master module 260 via CAN communication.

In some embodiments, the analog front end 226 may measure the voltage state of some of the plurality of battery cells in the battery module 210, convert it into a digital signal, and transmit it to the battery management master module 260. In some embodiments, the battery management master module 260 may not receive voltage measurement data associated with some of the plurality of battery cells. This may be due to a failure of some measurement interfaces, balancing circuits, analog front ends, etc. In this case, the battery management master module 260 may estimate the SOC of the battery module 210 based on a composite probability variable model associated with the plurality of battery cells and the received voltage measurement data of some battery cells.

In some embodiments, only some of the plurality of battery cells in the battery module 210 may be connected to voltage measurement sensors. For example, only the first battery cell and the last battery cell of the plurality of battery cells connected in series may be connected to the voltage measurement sensors. In this case, the battery management master module 260 may receive only the voltage measurement data of the first battery cell and the voltage measurement data of the last battery cell from the battery management module 220. For example, the battery management master module 260 may not receive voltage measurement data of the remaining battery cells other than the first battery cell and the last battery cell out of the plurality of battery cells connected in series. In this case, the battery management master module 260 may estimate the SOC of the battery module 210 based on a composite probability variable model associated with the plurality of battery cells, the voltage measurement data of the first battery cell, and the voltage measurement data of the last battery cell. With such a configuration, manufacturing costs can be lowered by reducing the number of voltage measurement sensors, measurement interfaces, and analog front ends used in the battery management module 220.

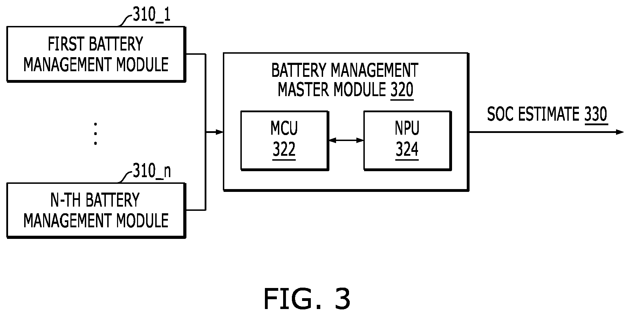

FIG. 3 is a block diagram of a battery system for estimating an SOC of each battery module in accordance with some embodiments of the present disclosure. Referring to FIG. 3, a battery management master module 320 may be connected to battery management modules 310_1, ..., 310_n. The battery management master module 320 may receive voltage measurement data of some battery cells from each battery management module 310_1, ..., 310_n, and generate and output an SOC estimate value 330 of each battery module based on the received data.

In some embodiments, the battery management master module 320 may include a microcontroller unit (MCU) 322 and a neural processing unit (NPU) 324 in order to generate the SOC estimate value 330. FIG. 3 shows that the battery management master module 320 comprises the MCU 322 and the NPU 324, but is not limited thereto. For example, the battery management master module 320 may further include additional components or may not include some of the MCU 322 and NPU 324.

In some embodiments, the MCU 322 may perform main logic operations in the process of estimating the SOC of each battery module based on voltage measurement data of some battery cells. The NPU 324 may assist the MCU 322 and perform vector operations and/or matrix operations necessary for estimating the voltage of each battery cell, such as Kalman filter operations.

In some embodiments, the NPU 324 may perform a Kalman filter prediction step and a correction step. For example, the NPU 324 may perform prediction and correction tasks of the state variables and error covariance of the system in the Kalman filter operation. Further, the NPU 324 may also perform a filtering task of separating actual target signals from input data containing noise. Moreover, the NPU 324 may effectively perform correction tasks for process noise or observation noise matrices that occur when measuring the voltage of the battery cells.

With such a configuration, through MCU-NPU co-processing in which the NPU 324 processes various tasks required in the SOC estimation process of the battery modules and the MCU 322 and the NPU 324 feed back to each other, the battery management master module 320 can relatively quickly, accurately, and resource-efficiently handle the process of estimating the SOC of each battery module based on the voltage measurement data of some battery cells.

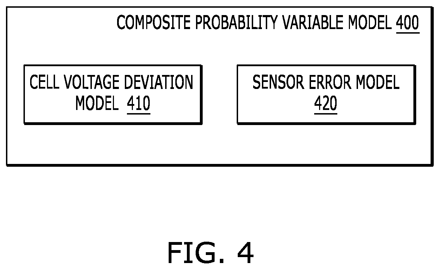

FIG. 4 is a diagram showing a composite probability variable model 400 used to estimate a battery module SOC according to some embodiments of the present disclosure. Referring to FIG. 4, the composite probability variable model 400 may include a cell voltage deviation model 410 and a sensor error model 420. Here, the cell voltage deviation model 410 and the sensor error model 420 may be probabilistically independent of each other. In one example, each of the composite probability variable model 400, the cell voltage deviation model 410, and the sensor error model 420 may be a probability density function (PDF) that includes mean value and standard deviation information for particular data.

In some embodiments, the composite probability variable model 400 including the cell voltage deviation model 410 and the sensor error model 420 may be generated in advance before the battery module SOC estimation process. For example, the composite probability variable model 400 may be pre-generated during the battery system development/production step.

In some embodiments, the cell voltage deviation model 410 may include voltage mean value and standard deviation information associated with a particular type of battery cell included in the battery module. For example, the cell voltage deviation model 410 may be associated with specifications, manufacturing deviations, etc., of a particular battery cell.

In some embodiments, the sensor error model 420 may include error mean value and standard deviation information of an instrument (e.g., a voltage measurement sensor) itself that measures the voltage of each battery cell. For example, if the cell voltage deviation model 410 is an observation target, the sensor error model 420 may correspond to the observer. For example, the SOC of the observation target (e.g., the battery module) can be estimated based on the composite probability variable model 400 that takes into account not only the information on the observation target but also the information on the observer.

In some embodiments, the cell voltage deviation model 410 and the sensor error model 420 may follow a Gaussian distribution. For example, a cell voltage deviation model X may follow the following Gaussian distribution with mean voltage *µₓ* and standard deviation *σₓ*, as shown in Equation 1.${f}_{X} \left(x\right) = \frac{1}{{σ}_{x} \sqrt{2 π}} {e}^{- \frac{1}{2} {\left(\frac{x - {μ}_{x}}{{σ}_{x}}\right)}^{2}}$ Equation 1.

Further, a sensor error model Y may follow the following Gaussian distribution with mean sensor error *µ_{y}* and standard deviation *σ_{y}*, as shown in Equation 2.${f}_{Y} \left(y\right) = \frac{1}{{σ}_{y} \sqrt{2 π}} {e}^{- \frac{1}{2} {\left(\frac{y - {μ}_{y}}{{σ}_{y}}\right)}^{2}}$ Equation 2.

In this case, assuming that the cell voltage deviation model X and the sensor error model Y are probabilistically independent, a composite probability variable model Z may follow the following Gaussian distribution with mean *µ_{z}* = *µₓ* + *µ_{y}* and standard deviation ${σ}_{z} = \sqrt{{{σ}_{x}}^{2} + {{σ}_{y}}^{2}}$, as shown in Equation 3.${f}_{Z} \left(z\right) = \frac{1}{{σ}_{z} \sqrt{2 π}} {e}^{- \frac{1}{2} {\left(\frac{z - {μ}_{z}}{{σ}_{z}}\right)}^{2}}$ Equation 3.

In some embodiments, a battery system (e.g., the NPU 324 in FIG. 3) may perform a battery SOC estimation operation (e.g., a linear Kalman filter operation, an extended Kalman filter (EKF) operation, etc.) based on the newly synthesized composite probability variable model 400.

With such a configuration, the voltage of each battery cell can be estimated more accurately by taking into account not only the voltage characteristics of the particular type of battery cell itself but also the characteristics of the sensor that measures the corresponding battery cell when estimating the SOC of a battery module. Accordingly, battery state information, such as the SOC and SOH of the battery module, can be estimated relatively precisely.

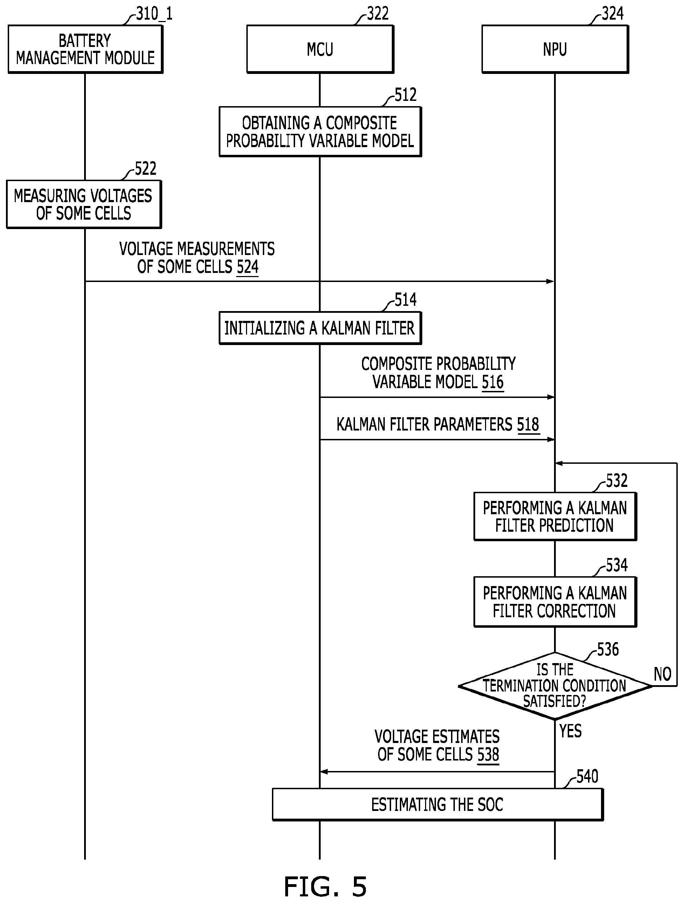

FIG. 5 is a diagram showing an example of estimating an SOC of a battery module according to some embodiments of the present disclosure. An MCU 322 and an NPU 324 may be included in a battery management master module, and a battery management module 310_1 may communicate with the battery management master module by using a communication module, etc.

In some embodiments, the MCU 322 may obtain a composite probability variable model (512). Here, the composite probability variable model may be a probability density function generated based on a battery cell voltage deviation model and a sensor error model. For example, the composite probability variable model may include a mean value (*µ_{z}*) obtained by taking both a cell voltage mean value (*µₓ*) and a sensor error mean value (*µ_{y}*), and a standard deviation (*σ_{z}*) obtained by taking both a standard deviation of the cell voltage (*σₓ*) and a standard deviation of the sensor error (*σ_{y}*).

In some embodiments, the battery management module 310_1 may measure the voltages of some battery cells of a plurality of battery cells included in a particular battery module (522). Here, the MCU 322 may select (sample) some battery cells for which the battery management module 310_1 will measure voltages out of the plurality of battery cells included in the particular battery module. For example, each battery module may have a plurality of battery cells connected in series, parallel, or a mixture of series and parallel. If a plurality of battery cells is connected in series in one battery module, the MCU 322 may select the first battery cell and the last battery cell out of the plurality of battery cells connected in series and allow the battery management module 310_1 to measure the voltages of those two battery cells. The voltage measurements of some battery cells 524 may be transmitted to the MCU 322 and the NPU 324. The voltage measurements of some battery cells 524 may include voltage measurement data of a first battery cell associated with the first battery cell and voltage measurement data of a second battery cell associated with the last battery cell.

With such a configuration, the number of sensors, and measurement interfaces and analog front-ends (AFEs) of the battery management module used when monitoring the battery cells can be reduced. Even if only the first and last battery cells are sampled and measured instead of monitoring all the battery cells connected in series in the battery module, the SOC state of the entire battery module can be estimated precisely. Therefore, the battery SOC estimation calculation performance can be advantageous and the reliability of the battery system can be improved while reducing the battery system hardware cost and lowering the overall production unit cost.

FIG. 5 shows that the battery management module 310_1 measures the voltages of some cells and transmits the voltage measurements of some cells 524 to the MCU 322 and the NPU 324, after the MCU 322 obtains the composite probability variable model and before it performs the Kalman filter initialization, but is not limited thereto. For example, the battery management module 310_1 may measure the voltages of some cells and transmit the voltage measurements of some cells 524 to the MCU 322 and the NPU 324, after the MCU 322 performs the Kalman filter initialization and before it performs the Kalman filter prediction.

In some embodiments, the MCU 322 may initialize the Kalman filter (514) based on the obtained composite probability variables and/or the voltage measurements of some cells 524, and generate parameter values required for the Kalman filter operation. Here, the parameter values required for the Kalman filter operation may include a priori estimates (or predicted values), error covariances, system module factors, etc.

In some embodiments, the MCU 322 may set an initial estimate (*x̂*₀) (i.e., an estimate, in discrete time *k* = 0 and continuous time *t =* 0, of the voltage of a battery cell sampled to measure the voltage out of a plurality of battery cells included in a particular battery module) of a state variable (e.g., the voltage value of a battery cell) of the Kalman filter. For example, the MCU 322 may set the mean value (*µ_{z}*) in the composite probability variable model as the initial estimate (*x̂*₀) of the battery cell voltage. In another example, the MCU 322 may generate the initial estimate (*x̂*₀) of the battery cell voltage based on the voltage measurements of some cells 524 received from the battery management module 310_1. Further, the MCU 322 may arbitrarily set an initial estimate (*P*₀) of the error covariance. Here, the initial value of the error covariance 323 may be set high and updated later as the Kalman filter operation progresses. Moreover, the MCU 322 may generate/set a measurement noise covariance (*R*) of the Kalman filter based on the standard deviation (*σ_{z}*) of the composite probability variable model Z. Furthermore, the MCU 322 may set/generate parameter values of the system model based on predetermined values obtained experimentally.

In some embodiments, the MCU 322 may store the obtained composite probability variable model and the generated initial values of the Kalman filter parameters in a memory or storage. Further, the MCU 322 may transmit the composite probability variable model 516 and the initialized Kalman filter parameters 518 to the NPU 324 that will perform the Kalman filter operation.

In some embodiments, the NPU 324 may perform a Kalman filter prediction step (532) based on the received composite probability variable model 516 and the initialized Kalman filter parameters 518. For example, the NPU 324 may generate an initial predicted value (*x̂*₀⁻) of the battery cell voltage based on the initial estimate (*x̂*₀) set as the mean value (*µ_{z}*) of the composite probability variable model according to the formulae below. Here, the predicted value may refer to an a priori estimate, as shown in Equations 4-5.${{\hat{x}}_{1}}^{-} = A {\hat{x}}_{0}$ Equation 4. ${{\hat{x}}_{1}}^{-} = A {\hat{x}}_{0} = {Aμ}_{z} = A \left({μ}_{x}+{μ}_{y}\right)$ Equation 5.

In the above equations, A may represent a value obtained by modeling the equation of motion of the system, i.e., the way the voltage of the battery cell to be measured changes over time.

Further, the NPU 324 may generate an error covariance initial prediction value (*P*₁⁻) based on the error covariance estimate (*P*₀) set arbitrarily by the MCU 322 according to the formula (Equation 6) below:${{P}_{1}}^{-} = {AP}_{0} {A}^{T} + Q$ Equation 6.
where Q may refer to the system noise covariance.

In some embodiments, the NPU 324 may perform a Kalman filter correction step (534) based on the composite probability variable model Z, the Kalman filter parameters 518, and the voltage measurements of some battery cells 524. For example, the NPU 324 may update the battery cell voltage prediction value and the error covariance prediction value generated in the Kalman filter prediction step and generate a battery cell voltage estimate and an error covariance estimate (a posteriori estimates).

In one example, the correction step during the Kalman filter operation may include calculating a Kalman gain (*Kₖ*), updating the state variable estimate (x̂*ₖ*) based on the measured value (*zₖ*), the predicted values ( ${\hat{x}}_{k}^{-} , {P}_{k}^{-}$), and the Kalman gain (*Kₖ*), and updating the error covariance (*Pₖ*), according to the formulae below (Equations 7-9):
${K}_{k} = {P}_{k}^{-} {H}^{T} {\left({HP}_{k}^{-}{H}^{T}+R\right)}^{-}$ Equation 7.
${\hat{x}}_{k} = {\hat{x}}_{k}^{-} + {K}_{k} \left({z}_{k}-H{\hat{x}}_{k}^{-}\right)$ Equation 8.
${P}_{k} = {P}_{k}^{-} - {K}_{k} {HP}_{k}^{-}$ Equation 9.
where R may represent the measurement noise covariance (R) of the Kalman filter, and H may represent a predefined matrix that represents the relationship between the battery voltage measurements and the battery estimates.

The error covariance (*Pₖ*) generated along with the state variable estimate in the Kalman filter correction step may be used as a measure to indirectly determine the accuracy of the corresponding state variable estimate (x̂*ₖ*). In one example, the NPU 324 may determine whether a termination condition is satisfied (536) based on the corrected error covariance (*Pₖ*) and a predetermined recursion termination threshold. If it is determined that the termination condition is not satisfied, the NPU 324 may repeat performing the Kalman filter prediction (532) and performing the Kalman filter correction (534) based on new voltage measurements of some cells. If it is determined that the termination condition is satisfied, the NPU 324 may terminate the Kalman filter operation. For example, if the error covariance (*P*ₙ) corrected n times is lower than a predetermined threshold (*Pₜₕ*), the NPU 324 may interrupt the Kalman filter recursion operation and output voltage estimates (*x̂ₙ*) of some battery cells 538 that have been corrected so far.

In some embodiments, if the Kalman filter operation is terminated according to the termination condition, the NPU 324 may transmit the voltage estimates of some battery cells 538 to the MCU 322. The voltage estimates of some battery cells 538 may include a voltage estimate of a first battery cell associated with the first battery cell and a voltage estimate of a second battery cell associated with the last battery cell. Thereafter, the MCU 322 and/or the NPU 324 may estimate the SOC of the battery module (540).

With such a configuration, the MCU 322 can perform main operation tasks such as the pre-processing process of the Kalman filter operation of the NPU 324, and the Kalman filter operation can be optimized via NPU 324 co-processing, thereby improving operational efficiency.

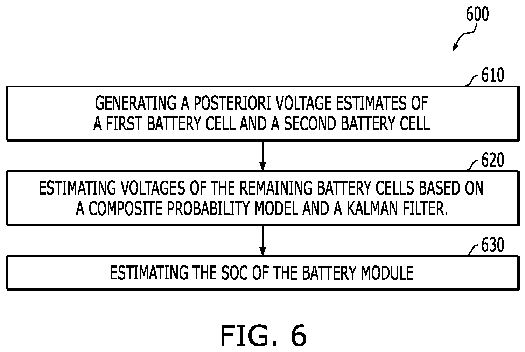

FIG. 6 is a diagram showing an example of a method 600 for estimating an SOC of a battery module based on voltage estimates of some battery cells according to some embodiments of the present disclosure. In some embodiments, the method 600 may be performed by an MCU and/or an NPU. Referring to FIG. 6, the method 600 may begin with the NPU generating voltage estimates of a first battery cell and a second battery cell (610). For example, as described above in FIG. 5, when the NPU terminates the Kalman filter operation according to the termination condition, the voltage estimates of the first battery cell and the second battery cell may be generated.

In some embodiments, the NPU may estimate the voltages of the remaining battery cells included in the battery module (620) by using the voltage estimate of the first battery cell, the voltage estimate of the second battery cell, a composite probability model, and a Kalman filter operation. Thereafter, the SOC of the battery module may be estimated based on the MCU and/or the voltage estimates of all the battery cells included in the battery module (630).

FIG. 6 shows that the MCU and/or the NPU estimates the SOC of the battery module based on the voltage estimates of all the battery cells included in the battery module, but there are no limitations on this. For example, the MCU 322 and/or the NPU may estimate the SOC of the battery module based on the voltage estimates of the first battery cell and the second battery cell (630). In one example, the MCU 322 and/or the NPU may estimate the SOC of the battery module by using the voltage estimates of the first battery cell and the second battery cell, the composite probability variable model, and the Kalman filter operation. In another example, the MCU 322 and/or the NPU may estimate the SOC of the battery module based on a mean value of the voltage estimates of the first battery cell and the second battery cell.

With such a configuration, the SOC of the battery module can be estimated accurately and quickly without measuring the voltages of all of the plurality of battery cells included in the particular battery module or performing a Kalman filter operation on all of the battery cells. For example, if the battery module has a plurality of battery cells connected in series, the SOC of the battery module can be estimated more accurately using only the voltage measurement data of two battery cells, i.e., the first and last battery cells. Accordingly, the processing time can be shortened when estimating the battery module SOC and the power consumption can be reduced, which in turn can improve the overall performance, service life, durability, etc., of devices equipped with the battery system (e.g., electric vehicles, etc.).

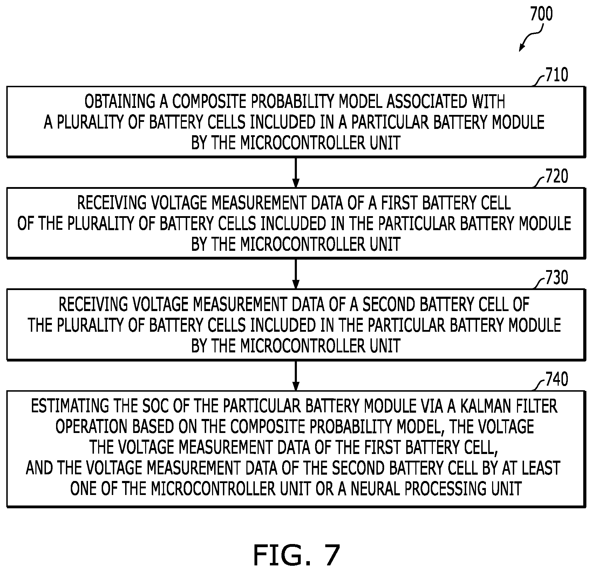

FIG. 7 is a flowchart showing a method 700 of estimating a state of charge of a battery module in accordance with some embodiments of the present disclosure. The method may be performed by at least one processor (e.g., a microcontroller unit, a neural processing unit, etc.) of a battery system or an information processing system outside a vehicle. The method 700 may begin with the microcontroller unit obtaining a composite probability variable model associated with a plurality of battery cells included in a particular battery module (710). Here, the composite probability variable model may be a model generated based on a cell voltage deviation model associated with the plurality of battery cells and a sensor error model associated with voltage measurement sensors connected to some of the plurality of battery cells. For example, the composite probability variable model may be generated by assuming that the cell voltage deviation model and the sensor error model are probabilistically independent of each other. The composite probability variable model, the cell voltage deviation model, and the sensor error model may be probability density functions that follow a Gaussian distribution.

In some embodiments, the microcontroller unit may receive voltage measurement data of a first battery cell of the plurality of battery cells included in the particular battery module (720). For example, the microcontroller unit may receive a plurality of voltage measurements of the first battery cell measured at a plurality of times as voltage measurement data. For example, the microcontroller unit may receive a first voltage measurement of the first battery cell measured at a first time and receive a second voltage measurement of the first battery cell measured at a second time.

Similarly, the microcontroller unit may receive voltage measurement data of a second battery cell of the plurality of battery cells included in the particular battery module (730). For example, the microcontroller unit may receive a plurality of voltage measurements of the second battery cell measured at a plurality of times as voltage measurement data. For example, the microcontroller unit may receive a first voltage measurement of the second battery cell measured at a first time and receive a second voltage measurement of the second battery cell measured at a second time.

In some embodiments, the first battery cell may be a first battery cell of the plurality of battery cells connected in series, and the second battery cell may be a last battery cell of the plurality of battery cells connected in series.

In some embodiments, the microcontroller unit may not receive voltage measurement data associated with some of the remaining battery cells other than the first battery cell and the second battery cell out of the plurality of battery cells.

In some embodiments, the first battery cell may be connected to a first voltage measurement sensor, the second battery cell may be connected to a second voltage measurement sensor, and the remaining battery cells other than the first battery cell and the second battery cell out of the plurality of battery cells may not be connected to a voltage measurement sensor.

In some embodiments, the microcontroller unit and/or a neural processing unit may estimate an SOC of the particular battery module via a Kalman filter operation based on the composite probability variable model, the voltage measurement data of the first battery cell, and the voltage measurement data of the second battery cell (740).

In some embodiments, estimating the SOC may include generating parameters associated with a Kalman filter by the microcontroller unit, generating an a posteriori voltage estimate of the first battery cell via a Kalman filter operation based on the generated parameters and the voltage measurement data of the first battery cell by the neural processing unit, and generating an a posteriori voltage estimate of the second battery cell via a Kalman filter operation based on the generated parameters and the voltage measurement data of the second battery cell by the neural processing unit.

In some embodiments, generating the parameters may include setting a mean value of the composite probability variable model as an initial state estimate of the Kalman filter, or generating an initial state estimate of the Kalman filter based on at least some of the voltage measurement data of the first battery cell or the voltage measurement data of the second battery cell.

In some embodiments, generating the parameters may include generating a measurement noise covariance of the Kalman filter based on a standard deviation value of the composite probability variable model.

In some embodiments, estimating the SOC may further include estimating the SOC of the particular battery module via the Kalman filter operation based on the a posteriori voltage estimate of the first battery cell, the a posteriori voltage estimate of the second battery cell, the composite probability variable model, and the generated parameters.

In some embodiments, estimating the SOC may further include generating an a posteriori voltage estimate of each of the remaining battery cells other than the first battery cell and the second battery cell out of the plurality of battery cells via the Kalman filter operation based on the a posteriori voltage estimate of the first battery cell, the a posteriori voltage estimate of the second battery cell, the composite probability variable model, and the generated parameters, and estimating the SOC of the particular battery module based on the a posteriori voltage estimate of each of the plurality of battery cells.

In some embodiments, estimating the SOC may further include estimating the SOC of the particular battery module based on a mean value of the a posteriori voltage estimate of the first battery cell and the a posteriori voltage estimate of the second battery cell.

In some embodiments, the microcontroller unit may perform cell balancing on the particular battery module based on the estimated SOC.

In some embodiments, the microcontroller unit may output the estimated SOC of the particular battery module.

The flowchart shown in FIG. 7 and the foregoing description are merely examples and some embodiments may be implemented differently. For example, one or more steps may be omitted, the order of each step may be changed, one or more steps may be performed in an overlapping manner, or one or more steps may be repeated multiple times.

FIG. 7 shows that the microcontroller unit and/or the neural processing unit in the battery management master module performs each step of the method 700, but there are no limitations on this. For example, the battery management master module and/or the information processing system (e.g., an external server) outside the vehicle may perform each step of the method 700.

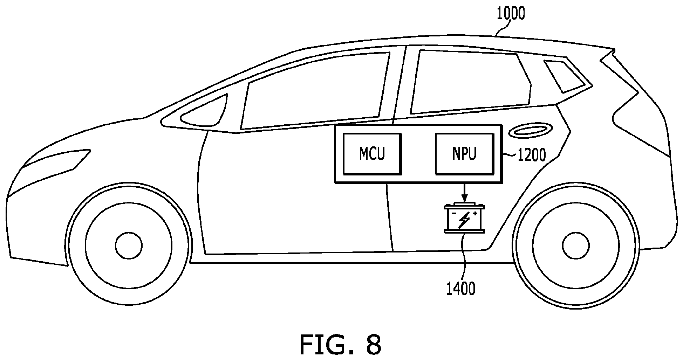

FIG. 8 is a diagram showing an example in which an NPU is included in a vehicle 1000 in accordance with some embodiments of the present disclosure. Referring to FIG. 8, the vehicle 1000 may include a battery management master module 1200 and a battery 1400. The battery management master module 1200 may include a microcontroller unit (MCU) and a neural processing unit (NPU). The battery 1400 may include a plurality of battery modules. Each battery module may include a plurality of battery cells.

The battery management master module 1200 may receive voltage measurement data of some battery cells for each battery module. In this case, the MCU and NPU in the battery management master module 1200 may estimate the SOC of each battery module by co-processing the voltage measurement data of some battery cells for each battery module. Based on the estimated SOC of the plurality of battery modules, the battery management master module 1200 may perform cell balancing on the plurality of battery modules.

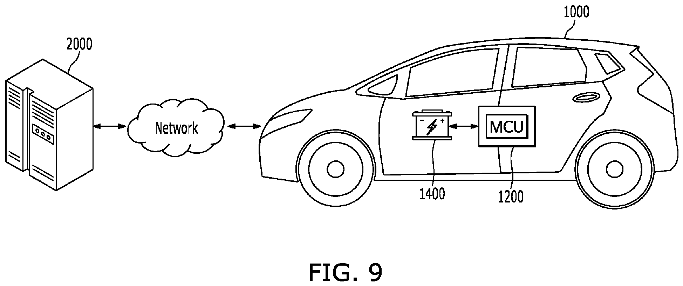

FIG. 9 is a diagram showing an example in which a vehicle 1000 and an information processing system 2000 communicate with each other in accordance with some embodiments of the present disclosure. Referring to FIG. 9, the vehicle 1000 may include a battery management master module 1200, a battery 1400, and a communication part (not shown). The vehicle 1000 may transmit and receive data to and from the information processing system 2000 over a network using the communication part. The information processing system 2000 and the battery management master module 1200 may each include at least one processor. For example, the battery management master module 1200 may include a microcontroller unit (MCU), and the information processing system 2000 may include a neural processing unit (NPU). The information processing system 2000 may be a server outside the vehicle.

The vehicle 1000 may transfer voltage measurement data of some battery cells for each battery module to the information processing system 2000 over a network. The information processing system 2000 may include an operating system and at least one program code.

In some embodiments, the information processing system 2000 may perform some or all of the functions of the battery management master module 1200 shown in FIG. 8. For example, the information processing system 2000 may estimate the SOC of each battery module by processing voltage measurement data of some battery cells for each battery module. The information processing system 2000 may transmit the estimated SOC of each battery module to the vehicle 1000. In this case, the battery management master module 1200 may perform cell balancing on a plurality of battery modules based on the estimated SOC of the plurality of battery modules.

With such a configuration, the battery management master module 1200 can generate the SOC estimate of the battery module more quickly and accurately by utilizing the information processing system 2000 connected to the vehicle 1000 with a network beyond the limits of the internal module performance of the vehicle 1000. Further, because the information processing system 2000 is present outside the vehicle 1000, the information processing system 2000 can compare and analyze information on the vehicle 1000 and information on other vehicles in real time. Accordingly, the information processing system 2000 can integrate and manage battery state information of a plurality of vehicles.

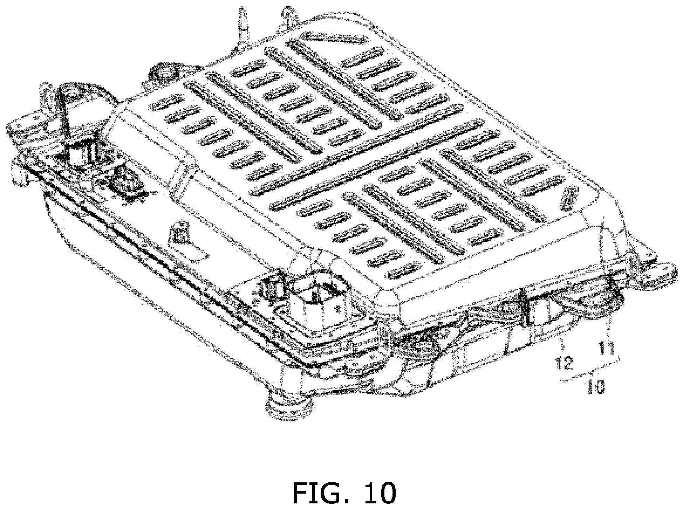

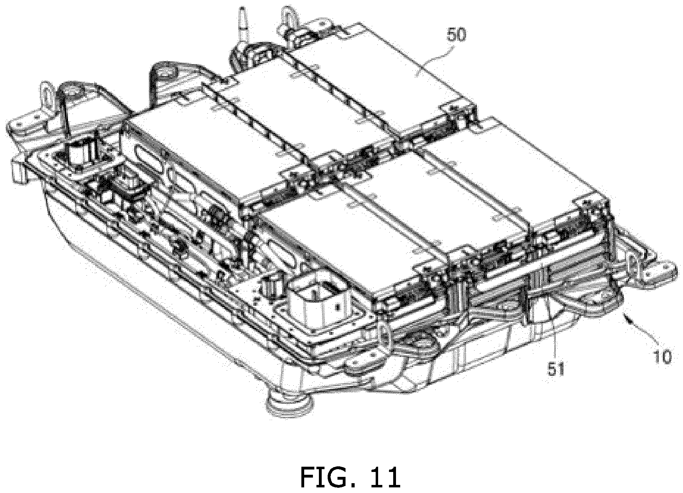

FIGS. 10 and 11 show a battery pack according to one or more embodiments of the present disclosure.

The battery pack may include a plurality of battery modules 50 and a housing 10 for accommodating the plurality of battery modules 50. For example, the housing 10 may include first and second housings 11 and 12 coupled in opposite directions through the plurality of battery modules 50. The plurality of battery modules 50 may be electrically connected to each other by using a bus bar 51, and the plurality of battery modules 50 may be electrically connected to each other in a series/parallel or series-parallel mixed method, thereby obtaining desired (e.g., required) electrical output.

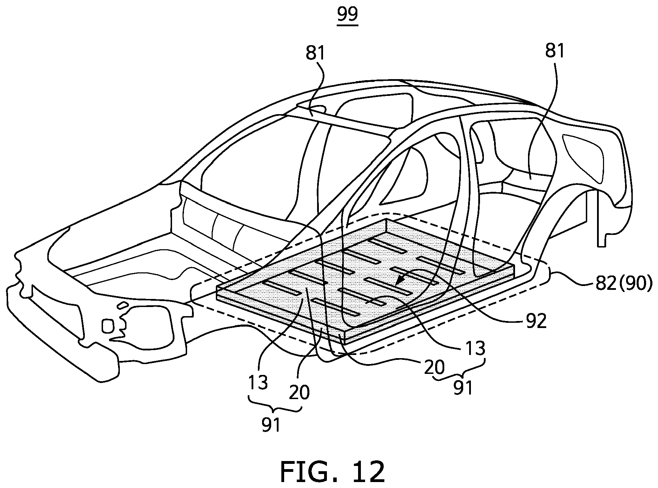

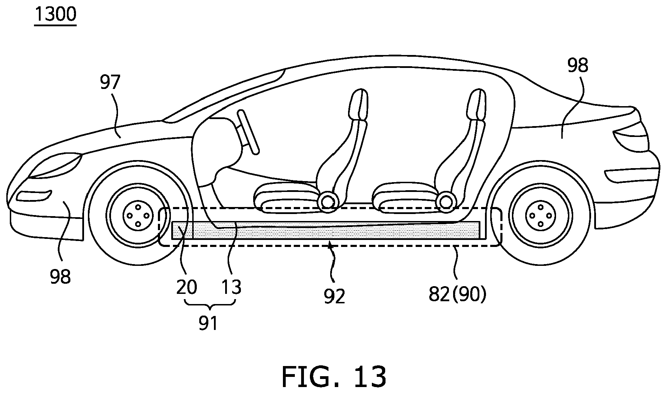

FIGS. 12 and 13 show a vehicle body and vehicle body parts having a battery pack according to one or more embodiments of the present disclosure.

In FIG. 12, a battery pack 91 may include a battery pack cover 13, which is a part of a vehicle underbody 92, and a pack frame 20 disposed under the vehicle underbody 92. The pack frame 20 and the battery pack cover 13 may be integrally formed with a vehicle floor 82.

The vehicle underbody 92 separates the inside and outside of a vehicle, and the pack frame 20 may be disposed outside the vehicle.

FIG. 13 is a schematic side view of a vehicle according to one or more embodiments of the present disclosure.

A vehicle 1300 may be formed by combining additional parts, such as a hood 97 in front of the vehicle and fenders 98 respectively located in the front and rear of the vehicle to a vehicle body 99.

The vehicle 1300 may further include a vehicle floor 82, which is one of the vehicle body parts 90 including the battery pack 91 including the pack frame 20 and the battery pack cover 13.

The methods described above may be provided as computer programs stored on a computer-readable recording medium for execution on a computer. The medium may continue to store computer-executable programs or temporarily store them for execution or download. Further, the medium may be a variety of recording or storage means in the form of a single piece of hardware or a combination of several pieces of hardware, and is not limited to media directly connected to a computer system but may be distributed over a network. Examples of media may be those configured to store program instructions, including magnetic media such as hard disks, floppy disks, and magnetic tapes, optical recording media such as CD-ROMs and DVDs, magneto-optical media such as floptical disks, ROM, RAM, flash memory, etc. Moreover, examples of other media may include recording or storage media managed by app stores that distribute applications, sites that supply or distribute various other software, servers, etc.

The methods, operations, or techniques of the present disclosure may be implemented by a variety of means. For example, these techniques may be implemented in hardware, firmware, software, or a combination thereof. Those skilled in the art will appreciate that the various example logic blocks, modules, circuits, and algorithm steps described in connection with the disclosure herein may be implemented in electronic hardware, computer software, or a combination of both. To clearly describe this interchangeability of hardware and software, the various example components, blocks, modules, circuits, and steps have been described above generally in terms of their functionality. Whether such functionality is implemented as hardware or software depends on the particular application and design requirements imposed on the overall system. Those skilled in the art may implement the described functionality in a variety of ways for each particular application, but such implementations should not be construed as departing from the scope of the present disclosure.

In hardware implementations, the processing units used to perform the techniques may be implemented within one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computers, or combinations thereof.

Therefore, the various example logic blocks, modules, and circuits described in connection with the present disclosure may be implemented or performed in any combination of general-purpose processors, DSPs, ASICs, FPGAs or other programmable logic devices, discrete gate or transistor logic, discrete hardware components, or those designed to perform the functions described herein. The general-purpose processor may be a microprocessor, but in other examples, the processor may be any conventional processor, controller, microcontroller, or state machine. The processor may also be implemented as a combination of computing devices, for example, a combination of a DSP and a microprocessor, a plurality of microprocessors, one or more microprocessors in conjunction with a DSP core, or any other configurations.

In firmware and/or software implementations, the techniques may be implemented as instructions stored on a computer-readable medium such as random-access memory (RAM), read-only memory (ROM), non-volatile random-access memory (NVRAM), PROM (programmable read-only memory), EPROM (erasable programmable read-only memory), EEPROM (electrically erasable PROM), flash memory, compact discs (CDs), magnetic or optical data storage devices, etc. The instructions may be executable by one or more processors, and may cause the processor(s) to perform certain aspects of the functionality described in the present disclosure.

If implemented in software, the techniques may be stored on or transmitted via a computer-readable medium as one or more instructions or code. Computer-readable media include both computer storage media and communication media, including any medium that facilitates the transmission of a computer program from one place to another. The storage media may be any available media that can be accessed by a computer. By way of non-limiting example, the computer-readable media may include RAM, ROM, EEPROM, CD-ROM or other optical disc storages, magnetic disk storage or other magnetic storage devices, or any other media that can be used to transport or store the desired program code in the form of instructions or data structures and that can be accessed by a computer. Further, any access is referred appropriately to the computer-readable media.

For example, if the software is transmitted from websites, servers, or other remote sources using coaxial cables, fiber optic cables, twisted pair cables, digital subscriber lines (DSLs), or wireless technologies such as infrared, radio, and microwave, then the coaxial cables, fiber optic cables, twisted pair cables, digital subscriber lines, or wireless technologies such as infrared, radio, and microwave are included within the definition of media. As used herein, the disks and discs include CDs, laser discs, optical discs, digital versatile discs (DVDs), floppy disks, and Blu-ray discs, wherein the disks typically reproduce data magnetically, whereas the discs reproduce data optically using lasers. Combinations of the above should also be included within the scope of computer-readable media.

The software modules may reside in RAM memory, flash memory, ROM memory, EPROM memory, EEPROM memory, registers, a hard disk, a removable disk, a CD-ROM, or any other form of storage medium known. An example storage medium may be connected to the processor such that the processor can read information from or write information to the storage medium. In other examples, the storage medium may be integrated into the processor. The processor and storage medium may be present within an ASIC. The ASIC may be present within the user terminal. In other examples, the processor and storage medium may be present as separate components in the user terminal.

Although the embodiments have been described above as utilizing aspects of the presently disclosed subject matter in one or more standalone computer systems, the present disclosure is not limited thereto but may be implemented in conjunction with any computing environment, such as a network or distributed computing environment. Furthermore, aspects of the subject matter in the present disclosure may be implemented in a plurality of processing chips or devices, and storage may be affected similarly across a plurality of devices. These devices may include PCs, network servers, and portable devices.

Although the present disclosure has been described with reference to embodiments and drawings illustrating aspects thereof, the present invention is not limited thereto. Various modifications and variations can be made within the scope of the appended claims.

## Claims

1. A method (600, 700) of estimating a state of charge (SOC) of a battery module (50, 110_1, 110_2, 210) comprising:
obtaining, by a microcontroller unit (228, 322), a composite probability variable model (400, 516) associated with a plurality of battery (1400) cells (524) included in a particular battery module (50, 110_1, 110_2, 210);
receiving, by the microcontroller unit (228) voltage measurement data of a first battery (1400) cell (524) of the plurality of battery (1400) cells (524) included in the particular battery module (50, 110_1, 110_2, 210);
receiving, by the microcontroller unit (228, 322) voltage measurement data of a second battery (1400) cell (524) of the plurality of battery (1400) cells (524) included in the particular battery module (50, 110_1, 110_2, 210);
estimating, by the microcontroller unit (228, 322) and/or a neural processing unit (324), a SOC of the particular battery module (50, 110_1, 110_2, 210) via a Kalman filter operation based on the composite probability variable model (400, 516) the voltage measurement data of the first battery (1400) cell (524), and the voltage measurement data of the second battery (1400) cell (524); and
outputting the estimated SOC 330 of the particular battery module (50, 110_1, 110_2, 210).

2. The method (600, 700) as claimed in claim 1, wherein the first battery (1400) cell (524) is a battery (1400) cell (524) positioned first among the plurality of battery (1400) cells (524) connected in series, and
the second battery (1400) cell (524) is a battery (1400) cell (524) positioned last among the plurality of battery (1400) cells (524) connected in series.

3. The method (600, 700) as claimed in claim 1 or 2, wherein the microcontroller unit (228, 322) does not receive voltage measurement data associated with some of remaining battery (1400) cells (524) other than the first battery (1400) cell (524) and the second battery (1400) cell (524) out of the plurality of battery (1400) cells (524).

4. The method (600, 700) as claimed in claims 1 to 3, wherein the first battery (1400) cell (524) is connected to a first voltage measurement sensor,
the second battery (1400) cell (524) is connected to a second voltage measurement sensor, and
remaining battery (1400) cells (524) other than the first battery (1400) cell (524) and the second battery (1400) cell (524) out of the plurality of battery (1400) cells (524) are not connected to a voltage measurement sensor.

5. The method (600, 700) as claimed in claims 1 to 4, wherein the composite probability variable model (400, 516) is generated based on a cell voltage deviation model (410) associated with the plurality of battery (1400) cells (524) and a sensor error model (420) associated with voltage measurement sensors connected to some of the plurality of battery (1400) cells (524).

6. The method (600, 700) as claimed in claim 5, wherein the composite probability variable model (400, 516) is generated by assuming that the cell voltage deviation model (410) and the sensor error model (420) are probabilistically independent of each other.

7. The method (600, 700) as claimed in claims 1 to 6, wherein the estimating the SOC comprises:
generating, by the microcontroller unit (228 ,322) parameters associated with a Kalman filter;
generating, by the neural processing unit (324), an a posteriori voltage estimate of the first battery (1400) cell (524) via a Kalman filter operation based on the generated parameters and the voltage measurement data of the first battery (1400) cell (524); and
generating, by the neural processing unit (324), an a posteriori voltage estimate of the second battery (1400) cell (524) via a Kalman filter operation based on the generated parameters and the voltage measurement data of the second battery (1400) cell (524).

8. The method (600, 700) as claimed in claim 7, wherein the generating the parameters comprises:
setting a mean value of the composite probability variable model (400, 516)as an initial state estimate of the Kalman filter; or
generating an initial state estimate of the Kalman filter based on at least some of the voltage measurement data of the first battery (1400) cell (524) or the voltage measurement data of the second battery (1400) cell (524).

9. The method (600, 700) as claimed in claim 7 or 8, wherein the generating the parameters comprises:
generating a measurement noise covariance of the Kalman filter based on a standard deviation value of the composite probability variable model (400, 516) 400, 516.

10. The method (600, 700) as claimed in claims 7 to 9, wherein the estimating the SOC further comprises:
estimating the SOC of the particular battery module (50, 110_1, 110_2, 210) via the Kalman filter operation based on the a posteriori voltage estimate of the first battery (1400) cell (524), the a posteriori voltage estimate of the second battery (1400) cell (524), the composite probability variable model (400, 516) and the generated parameters.

11. The method (600, 700) as claimed in claims 7 to 10, wherein the estimating the SOC further comprises:
generating an a posteriori voltage estimate of each of remaining battery (1400) cells (524) other than the first battery (1400) cell (524) and the second battery (1400) cell (524) out of the plurality of battery (1400) cells (524) via the Kalman filter operation based on the a posteriori voltage estimate of the first battery (1400) cell (524), the a posteriori voltage estimate of the second battery (1400) cell (524), the composite probability variable model (400, 516) and the generated parameters; and
estimating the SOC of the particular battery module (50, 110_1, 110_2, 210) based on the a posteriori voltage estimate of each of the plurality of battery (1400) cells (524).

12. A battery system (100, 200) comprising:
a particular battery module (50, 110_1, 110_2, 210) comprising a plurality of battery (1400) cells (524); and
a battery management master module (260, 320, 1200) comprising a microcontroller unit (228) and a neural processing unit (324),
wherein the battery system (100, 200) is configured such that:
the microcontroller unit (228, 322) obtains a composite probability variable model (400, 516) associated with the plurality of battery (1400) cells (524) included in the particular battery module (50, 110_1, 110_2, 210),
the microcontroller unit (228 ,322) receives voltage measurement data of a first battery (1400) cell (524) of the plurality of battery (1400) cells (524) included in the particular battery module (50, 110_1, 110_2, 210) from the particular battery module (50, 110_1, 110_2, 210),
the microcontroller unit (228, 322) receives voltage measurement data of a second battery (1400) cell (524) of the plurality of battery (1400) cells (524) included in the particular battery module (50, 110_1, 110_2, 210) from the particular battery module (50, 110_1, 110_2, 210),
the microcontroller unit (228, 322) and/or the neural processing unit (324) estimates an SOC of the particular battery module (50, 110_1, 110_2, 210) via a Kalman filter operation based on the composite probability variable model (400, 516), the voltage measurement data of the first battery (1400) cell (524), and the voltage measurement data of the second battery (1400) cell (524), and
the microcontroller unit (228, 322) outputs the estimated SOC of the particular battery module (50, 110_1, 110_2, 210).

13. The battery system (100, 200) as claimed in claim 12, wherein the first battery (1400) cell (524) is a battery (1400) cell (524) positioned first among the plurality of battery (1400) cells (524) connected in series, and
the second battery (1400) cell (524) is a battery (1400) cell (524) positioned last among the plurality of battery (1400) cells (524) connected in series.

14. The battery system (100, 200) as claimed in claim 12 or 13, wherein the microcontroller unit (228, 322) does not receive voltage measurement data associated with some of remaining battery (1400) cells (524) other than the first battery (1400) cell (524) and the second battery (1400) cell (524) out of the plurality of battery (1400) cells (524).

15. The battery system (100, 200) as claimed in claims 12 to 14, wherein the first battery (1400) cell (524) is connected to a first voltage measurement sensor,
the second battery (1400) cell (524) is connected to a second voltage measurement sensor, and
remaining battery (1400) cells (524) other than the first battery (1400) cell (524) and the second battery (1400) cell (524) out of the plurality of battery (1400) cells (524) are not connected to a voltage measurement sensor.

## Patentansprüche

1. Verfahren (600, 700) zur Schätzung eines Ladezustands (SOC) eines Batteriemoduls (50, 110_1, 110_2, 210), umfassend:
Erhalten eines zusammengesetzten Wahrscheinlichkeitsvariablenmodells (400, 516) durch eine Mikrocontroller-Einheit (228, 322), das einer Vielzahl von in einem bestimmten Batteriemodul (50, 110_1, 110_2, 210) enthaltenen Batterie (1400)-Zellen (524) zugeordnet ist;
Empfangen von Spannungsmessdaten einer ersten Batterie (1400)-Zelle (524) der Vielzahl von im bestimmten Batteriemodul (50, 110_1, 110_2, 210) enthaltenen Batterie (1400)-Zellen (524) durch die Mikrocontroller-Einheit (228);
Empfangen von Spannungsmessdaten einer zweiten Batterie (1400)-Zelle (524) der Vielzahl von im bestimmten Batteriemodul (50, 110_1, 110_2, 210) enthaltenen Batterie (1400)-Zellen (524) durch die Mikrocontroller-Einheit (228, 322);
Schätzen eines SOC des bestimmten Batteriemoduls (50, 110_1, 110_2, 210) durch die Mikrocontroller-Einheit (228, 322) und/oder eine neuronale Verarbeitungseinheit (324) mittels einer Kalman-Filteroperation auf der Grundlage des zusammengesetzten Wahrscheinlichkeitsvariablenmodells (400, 516), der Spannungsmessdaten der ersten Batterie (1400)-Zelle (524) und der Spannungsmessdaten der zweiten Batterie (1400)-Zelle (524); und
Ausgeben des geschätzten SOC 330 des bestimmten Batteriemoduls (50, 110_1, 110_2, 210).

2. Verfahren (600, 700) nach Anspruch 1, wobei die erste Batterie (1400)-Zelle (524) eine Batterie (1400)-Zelle (524) ist, die an erster Stelle unter der Vielzahl in Reihe geschalteter Batterie (1400)-Zellen (524) angeordnet ist, und
die zweite Batterie (1400)-Zelle (524) eine Batterie (1400)-Zelle (524) ist, die an letzter Stelle unter der Vielzahl in Reihe geschalteter Batterie (1400)-Zellen (524) angeordnet ist.

3. Verfahren (600, 700) nach Anspruch 1 oder 2, wobei die Mikrocontroller-Einheit (228, 322) keine Spannungsmessdaten empfängt, die einigen der verbleibenden Batterie (1400)-Zellen (524) aus der Vielzahl von Batterie (1400)-Zellen (524), mit Ausnahme der ersten Batterie (1400)-Zelle (524) und der zweiten Batterie (1400)-Zelle (524), zugeordnet sind.

4. Verfahren (600, 700) nach den Ansprüchen 1 bis 3, wobei die erste Batterie (1400)-Zelle (524) mit einem ersten Spannungsmesssensor verbunden ist,
die zweite Batterie (1400)-Zelle (524) mit einem zweiten Spannungsmesssensor verbunden ist und
die verbleibenden Batterie (1400)-Zellen (524) aus der Vielzahl von Batterie (1400)-Zellen (524), mit Ausnahme der ersten Batterie (1400)-Zelle (524) und der zweiten Batterie (1400)-Zelle (524), nicht mit einem Spannungsmesssensor verbunden sind.

5. Verfahren (600, 700) nach den Ansprüchen 1 bis 4, wobei das zusammengesetzte Wahrscheinlichkeitsvariablenmodell (400, 516) auf der Grundlage eines Zellspannungsabweichungsmodells (410), das der Vielzahl von Batterie (1400)-Zellen (524) zugeordnet ist, und eines Sensorfehlermodells (420) erzeugt wird, das den mit einigen der Vielzahl von Batterie (1400)-Zellen (524) verbundenen Spannungsmesssensoren zugeordnet ist.

6. Verfahren (600, 700) nach Anspruch 5, wobei das zusammengesetzte Wahrscheinlichkeitsvariablenmodell (400, 516) unter der Annahme erzeugt wird, dass das Zellspannungsabweichungsmodell (410) und das Sensorfehlermodell (420) probabilistisch voneinander unabhängig sind.

7. Verfahren (600, 700) nach den Ansprüchen 1 bis 6, wobei das Schätzen des SOC Folgendes umfasst:
Erzeugen von Parametern, die mit einem Kalman-Filter zugeordnet sind, durch die Mikrocontroller-Einheit (228, 322);
Erzeugen einer a-posteriori-Spannungsschätzung der ersten Batterie (1400)-Zelle (524) durch die neuronale Verarbeitungseinheit (324) mittels einer Kalman-Filteroperation auf der Grundlage der erzeugten Parameter und der Spannungsmessdaten der ersten Batterie (1400)-Zelle (524); und
Erzeugen einer a-posteriori-Spannungsschätzung der zweiten Batterie (1400)-Zelle (524) durch die neuronale Verarbeitungseinheit (324) mittels einer Kalman-Filteroperation auf der Grundlage der erzeugten Parameter und der Spannungsmessdaten der zweiten Batterie (1400)-Zelle (524).

8. Verfahren (600, 700) nach Anspruch 7, wobei das Erzeugen der Parameter Folgendes umfasst:
Festlegen eines Mittelwerts des zusammengesetzten Wahrscheinlichkeitsvariablenmodells (400, 516) als Anfangszustandsschätzung des Kalman-Filters; oder
Erzeugen einer Anfangszustandsschätzung des Kalman-Filters auf der Grundlage zumindest einiger der Spannungsmessdaten der ersten Batterie (1400)-Zelle (524) oder der Spannungsmessdaten der zweiten Batterie (1400)-Zelle (524).

9. Verfahren (600, 700) nach Anspruch 7 oder 8, wobei das Erzeugen der Parameter Folgendes umfasst:
Erzeugen einer Messrauschkovarianz des Kalman-Filters auf der Grundlage eines Standardabweichungswerts des zusammengesetzten Wahrscheinlichkeitsvariablenmodells (400, 516) 400, 516.

10. Verfahren (600, 700) nach den Ansprüchen 7 bis 9, wobei das Schätzen des SOC ferner Folgendes umfasst:
Schätzen des SOC des bestimmten Batteriemoduls (50, 110_1, 110_2, 210) mittels der Kalman-Filteroperation auf der Grundlage der a-posteriori-Spannungsschätzung der ersten Batterie (1400)-Zelle (524), der a-posteriori-Spannungsschätzung der zweiten Batterie (1400)-Zelle (524), des zusammengesetzten Wahrscheinlichkeitsvariablenmodells (400, 516) und der erzeugten Parameter.

11. Verfahren (600, 700) nach den Ansprüchen 7 bis 10, wobei das Schätzen des SOC ferner Folgendes umfasst:
Erzeugen einer a-posteriori-Spannungsschätzung jeder der verbleibenden Batterie (1400)-Zellen (524) aus der Vielzahl von Batterie (1400)-Zellen (524), mit Ausnahme der ersten Batterie (1400)-Zelle (524) und der zweiten Batterie (1400)-Zelle (524), mittels der Kalman-Filteroperation auf der Grundlage der a-posteriori-Spannungsschätzung der ersten Batterie (1400)-Zelle (524), der a-posteriori-Spannungsschätzung der zweiten Batterie (1400)-Zelle (524), des zusammengesetzten Wahrscheinlichkeitsvariablenmodells (400, 516) und der erzeugten Parameter; und
Schätzen des SOC des bestimmten Batteriemoduls (50, 110_1, 110_2, 210) auf der Grundlage der a-posteriori-Spannungsschätzung jeder der Vielzahl von Batterie (1400)-Zellen (524).

12. Batteriesystem (100, 200), umfassend:
ein bestimmtes Batteriemodul (50, 110_1, 110_2, 210), das eine Vielzahl von Batterie (1400)-Zellen (524) umfasst; und
ein Batteriemanagement-Mastermodul (260, 320, 1200), das eine Mikrocontroller-Einheit (228) und eine neuronale Verarbeitungseinheit (324) umfasst,
wobei das Batteriesystem (100, 200) so konfiguriert ist, dass:
die Mikrocontroller-Einheit (228, 322) ein zusammengesetztes Wahrscheinlichkeitsvariablenmodell (400, 516) erhält, das der Vielzahl von im bestimmten Batteriemodul (50, 110_1, 110_2, 210) enthaltenen Batterie (1400)-Zellen (524) zugeordnet ist,
die Mikrocontroller-Einheit (228, 322) von dem bestimmten Batteriemodul (50, 110_1, 110_2, 210) Spannungsmessdaten einer ersten Batterie (1400)-Zelle (524) der Vielzahl von im bestimmten Batteriemodul (50, 110_1, 110_2, 210) enthaltenen Batterie (1400)-Zellen (524) empfängt,
die Mikrocontroller-Einheit (228, 322) von dem bestimmten Batteriemodul (50, 110_1, 110_2, 210) Spannungsmessdaten einer zweiten Batterie (1400)-Zelle (524) der Vielzahl von im bestimmten Batteriemodul (50, 110_1, 110_2, 210) enthaltenen Batterie (1400)-Zellen (524) empfängt,
die Mikrocontroller-Einheit (228, 322) und/oder die neuronale Verarbeitungseinheit (324) einen SOC des bestimmten Batteriemoduls (50, 110_1, 110_2, 210) mittels einer Kalman-Filteroperation auf der Grundlage des zusammengesetzten Wahrscheinlichkeitsvariablenmodells (400, 516), der Spannungsmessdaten der ersten Batterie (1400)-Zelle (524) und der Spannungsmessdaten der zweiten Batterie (1400)-Zelle (524) schätzen, und
die Mikrocontroller-Einheit (228, 322) den geschätzten SOC des bestimmten Batteriemoduls (50, 110_1, 110_2, 210) ausgibt.

13. Batteriesystem (100, 200) nach Anspruch 12, wobei die erste Batterie (1400)-Zelle (524) eine Batterie (1400)-Zelle (524) ist, die an erster Stelle unter der Vielzahl in Reihe geschalteter Batterie (1400)-Zellen (524) angeordnet ist, und
die zweite Batterie (1400)-Zelle (524) eine Batterie (1400)-Zelle (524) ist, die an letzter Stelle unter der Vielzahl in Reihe geschalteter Batterie (1400)-Zellen (524) angeordnet ist.

14. Batteriesystem (100, 200) nach Anspruch 12 oder 13, wobei die Mikrocontroller-Einheit (228, 322) keine Spannungsmessdaten empfängt, die einigen der verbleibenden Batterie (1400)-Zellen (524) aus der Vielzahl von Batterie (1400)-Zellen (524), mit Ausnahme der ersten Batterie (1400)-Zelle (524) und der zweiten Batterie (1400)-Zelle (524), zugeordnet sind.

15. Batteriesystem (100, 200) nach den Ansprüchen 12 bis 14, wobei die erste Batterie (1400)-Zelle (524) mit einem ersten Spannungsmesssensor verbunden ist,
die zweite Batterie (1400)-Zelle (524) mit einem zweiten Spannungsmesssensor verbunden ist und
die verbleibenden Batterie (1400)-Zellen (524) aus der Vielzahl von Batterie (1400)-Zellen (524), mit Ausnahme der ersten Batterie (1400)-Zelle (524) und der zweiten Batterie (1400)-Zelle (524), nicht mit einem Spannungsmesssensor verbunden sind.

## Revendications

1. Procédé (600, 700) d'estimation d'un état de charge (SOC) d'un module de batterie (50, 110_1, 110_2, 210) comportant:
l'obtention, par une unité de microcontrôleur (228, 322), d'un modèle de variable de probabilité composite (400, 516) associé à une pluralité d'éléments (524) de batterie (1400) inclus dans un module de batterie (50, 110_1, 110_2, 210) particulier;
la réception, par l'unité de microcontrôleur (228), de données de mesure de tension d'un premier élément (524) de batterie (1400) parmi la pluralité d'éléments (524) de batterie (1400) inclus dans le module de batterie (50, 110_1, 110_2, 210) particulier;
la réception, par l'unité de microcontrôleur (228, 322), de données de mesure de tension d'un deuxième élément (524) de batterie (1400) parmi la pluralité d'éléments (524) de batterie (1400) inclus dans le module de batterie (50, 110_1, 110_2, 210) particulier;
l'estimation, par l'unité de microcontrôleur (228, 322) et/ou une unité de traitement neuronal (324), d'un SOC du module de batterie (50, 110_1, 110_2, 210) particulier par l'intermédiaire d'une opération de filtre de Kalman basée sur le modèle de variable de probabilité composite (400, 516), les données de mesure de tension du premier élément (524) de batterie (1400), et les données de mesure de tension du deuxième élément (524) de batterie (1400); et
la délivrance en sortie du SOC 330 estimé du module de batterie (50, 110_1, 110_2, 210) particulier.

2. Procédé (600, 700) selon la revendication 1, dans lequel le premier élément (524) de batterie (1400) est un élément (524) de batterie (1400) positionné en premier parmi la pluralité d'éléments (524) de batterie (1400) connectés en série, et
le deuxième élément (524) de batterie (1400) est un élément (524) de batterie (1400) positionné en dernier parmi la pluralité d'éléments (524) de batterie (1400) connectés en série.

3. Procédé (600, 700) selon la revendication 1 ou 2, dans lequel l'unité de microcontrôleur (228, 322) ne reçoit pas de données de mesure de tension associées à certains des éléments (524) de batterie (1400) restants autres que le premier élément (524) de batterie (1400) et le deuxième élément (524) de batterie (1400) parmi la pluralité d'éléments (524) de batterie (1400).

4. Procédé (600, 700) selon l'une des revendications 1 à 3, dans lequel le premier élément (524) de batterie (1400) est connecté à un premier capteur de mesure de tension,
le deuxième élément (524) de batterie (1400) est connecté à un deuxième capteur de mesure de tension, et
les éléments (524) de batterie (1400) restants autres que le premier élément (524) de batterie (1400) et le deuxième élément (524) de batterie (1400) parmi la pluralité d'éléments (524) de batterie (1400) ne sont pas connectés à un capteur de mesure de tension.

5. Procédé (600, 700) selon les revendications 1 à 4, dans lequel le modèle de variable de probabilité composite (400, 516) est généré sur la base d'un modèle de déviation de tension d'élément (410) associé à la pluralité d'éléments (524) de batterie (1400) et d'un modèle d'erreur de capteur (420) associé à des capteurs de mesure de tension connectés à certains parmi la pluralité d'éléments (524) de batterie (1400).

6. Procédé (600, 700) selon la revendication 5, dans lequel le modèle de variable de probabilité composite (400, 516) est généré en supposant que le modèle de déviation de tension d'élément (410) et le modèle d'erreur de capteur (420) sont probabilistiquement indépendants l'un de l'autre.

7. Procédé (600, 700) selon les revendications 1 à 6, dans lequel l'estimation du SOC comporte:
la génération, par l'unité de microcontrôleur (228, 322), de paramètres associés à un filtre de Kalman;
la génération, par l'unité de traitement neuronal (324), d'une estimation de tension a posteriori du premier élément (524) de batterie (1400) par le biais d'une opération de filtre de Kalman basée sur les paramètres générés et les données de mesure de tension du premier élément (524) de batterie (1400); et
la génération, par l'unité de traitement neuronal (324), d'une estimation de tension a posteriori du deuxième élément (524) de batterie (1400) par le biais d'une opération de filtre de Kalman basée sur les paramètres générés et les données de mesure de tension du deuxième élément (524) de batterie (1400).

8. Procédé (600, 700) selon la revendication 7, dans lequel la génération de paramètres comporte:
la définition d'une valeur moyenne du modèle de variable de probabilité composite (400, 516) comme estimation d'état initial du filtre de Kalman; ou
la génération d'une estimation d'état initial du filtre de Kalman basée sur au moins une partie des données de mesure de tension du premier élément (524) de batterie (1400) ou des données de mesure de tension du deuxième élément (524) de batterie (1400).

9. Procédé (600, 700) selon la revendication 7 ou 8, dans lequel la génération de paramètres comporte:
la génération d'une covariance de bruit de mesure du filtre de Kalman basée sur une valeur d'écart type du modèle de variable de probabilité composite (400, 516) 400, 516.

10. Procédé (600, 700) selon les revendications 7 à 9, dans lequel l'estimation du SOC comporte en outre:
l'estimation du SOC du module de batterie (50, 110_1, 110_2, 210) particulier par le biais de l'opération de filtre de Kalman basée sur l'estimation de tension a posteriori du premier élément (524) de batterie (1400), l'estimation de tension a posteriori du deuxième élément (524) de batterie (1400), le modèle de variable de probabilité composite (400, 516) et les paramètres générés.

11. Procédé (600, 700) selon les revendications 7 à 10, dans lequel l'estimation du SOC comporte en outre:
la génération une estimation de tension a posteriori de chacun des éléments (524) de batterie (1400) restants autres que le premier élément (524) de batterie (1400) et le deuxième élément (524) de batterie (1400) parmi la pluralité d'éléments (524) de batterie (1400) par le biais de l'opération de filtre de Kalman basée sur l'estimation de tension a posteriori du premier élément (524) de batterie (1400), l'estimation de tension a posteriori du deuxième élément (524) de batterie (1400), le modèle de variable de probabilité composite (400, 516) et les paramètres générés; et
l'estimation du SOC du module de batterie (50, 110_1, 110_2, 210) particulier sur la base de l'estimation de tension a posteriori de chacun de la pluralité d'éléments (524) de batterie (1400).

12. Système de batterie (100, 200), comportant:
un module de batterie (50, 110_1, 110_2, 210) particulier comportant une pluralité d'éléments (524) de batterie (1400); et
un module maître de gestion de batterie (260, 320, 1200) comportant une unité de microcontrôleur (228) et une unité de traitement neuronal (324),
dans lequel le système de batterie (100, 200) est configuré de telle sorte que:
l'unité de microcontrôleur (228, 322) obtient un modèle de variable de probabilité composite (400, 516) associé à la pluralité d'éléments (524) de batterie (1400) inclus dans le module de batterie (50, 110_1, 110_2, 210) particulier,
l'unité de microcontrôleur (228, 322) reçoit les données de mesure de tension d'un premier élément (524) de batterie (1400) de la pluralité d'éléments (524) de batterie (1400) inclus dans le module de batterie (50, 110_1, 110_2, 210) particulier à partir du module de batterie (50, 110_1, 110_2, 210) particulier,
l'unité de microcontrôleur (228, 322) reçoit des données de mesure de tension d'un deuxième élément (524) de batterie (1400) de la pluralité d'éléments (524) de batterie (1400) inclus dans le module de batterie (50, 110_1, 110_2, 210) particulier depuis le module de batterie (50, 110_1, 110_2, 210) particulier,
l'unité de microcontrôleur (228, 322) et/ou l'unité de traitement neuronal (324) estime un SOC du module de batterie (50, 110_1, 110_2, 210) particulier par le biais d'une opération de filtre de Kalman basée sur le modèle de variable de probabilité composite (400, 516), les données de mesure de tension du premier élément (524) de batterie (1400) et les données de mesure de tension du deuxième élément (524) de batterie (1400), et
l'unité de microcontrôleur (228, 322) délivre en sortie le SOC estimé du module de batterie (50, 110_1, 110_2, 210) particulier.

13. Système de batterie (100, 200) selon la revendication 12, dans lequel le premier élément (524) de batterie (1400) est un élément (524) de batterie (1400) positionné en premier parmi la pluralité d'éléments (524) de batterie (1400) connectés en série, et
le deuxième élément (524) de batterie (1400) est un élément (524) de batterie (1400) positionné en dernier parmi la pluralité d'éléments (524) de batterie (1400) connectés en série.

14. Système de batterie (100, 200) selon la revendication 12 ou 13, dans lequel l'unité de microcontrôleur (228, 322) ne reçoit pas de données de mesure de tension associées à certains des éléments (524) de batterie (1400) restants autres que le premier élément (524) de batterie (1400) et le deuxième élément (524) de batterie (1400) parmi la pluralité d'éléments (524) de batterie (1400).

15. Système de batterie (100, 200) selon les revendications 12 à 14, dans lequel le premier élément (524) de batterie (1400) est connecté à un premier capteur de mesure de tension,
le deuxième élément (524) de batterie (1400) est connecté à un deuxième capteur de mesure de tension, et
les éléments (524) de batterie (1400) restants, autres que le premier élément (524) de batterie (1400) et le deuxième élément (524) de batterie (1400) parmi la pluralité d'éléments (524) de batterie (1400), ne sont pas connectés à un capteur de mesure de tension.
